# EUROPÄISCHE PATENTSCHRIFT

(11) **EP 1 115 905 B1**
(45) Veröffentlichungstag und Bekanntmachung des Hinweises auf die Patenterteilung: **06.11.2002**
(21) Anmeldenummer: 99969455.7
(22) Anmeldetag: 04.09.1999
(51) Int. Cl.: C23C 30/00, C23C 16/40

(54) **VERBUNDWERKSTOFF-ÜBERZUG UND VERFAHREN ZU SEINER HERSTELLUNG**
COMPOSITE MATERIAL COATING AND A METHOD FOR THE PRODUCTION THEREOF
REVETEMENT EN MATERIAU COMPOSITE ET PROCEDE PERMETTANT DE LE PRODUIRE

(30) Priorität: 24.09.1998 DE 19843743
(43) Veröffentlichungstag der Anmeldung: 18.07.2001
(73) Patentinhaber: Widia GmbH, 45145 Essen (DE)
(72) Erfinder: WESTPHAL, Hartmut, D-36466 Dermbach/Rhön (DE); SOTTKE, Volkmar, D-45479 Mülheim (DE)
(74) Vertreter: Vomberg, Friedhelm, Dipl.-Phys.
(86) Internationale Anmeldenummer: DE9902859
(87) Internationale Veröffentlichungsnummer: WO00017416

(56) Entgegenhaltungen:
- EP-A- 0 162 656
- EP-A- 0 302 984
- EP-A- 0 732 423
- EP-A- 0 786 536
- DE-A- 19 518 927
- PATENT ABSTRACTS OF JAPAN vol. 012, no. 186 (C-500), 31. Mai 1988 (1988-05-31) -& JP 62 290870 A (SUMITOMO ELECTRIC IND LTD), 17. Dezember 1987 (1987-12-17)

## Beschreibung

Die Erfindung betrifft einen Verbundwerkstoff aus einem beschichteten Hartmetall- oder Cermetgrundkörper auf dem die einzige oder bei einer mehrlagigen Beschichtung mindestens eine 0,5 µm bis 25 µm dicke Schicht, vorzugsweise die äußerste, eine Al₂O₃- und eine Phase enthält, die aus ZrO₂ und/oder HfO₂ besteht.

Bereits in der DE 27 36 982 A1 wird eine Verschleißschutzschicht für Formteile, insbesondere Werkzeuge, bestehend aus einem Formkörper, vorzugsweise aus Hartmetall, und einer oder mehreren Oberflächenschichten beschrieben, wovon mindestens eine Schutzschicht aus einer keramischen Matrix besteht, in die ein weiteres Material eingelagert ist. Die keramische Matrix und das eingelagerte Material besitzen eindeutig voneinander verschiedene thermische Ausdehnungskoeffizienten, so daß die Schutzschicht von feinsten Mikrorissen durchzogen ist. Als Einlagerungsmaterial in eine keramische Matrix aus Al₂O₃ wird unstabilisiertes und/oder teilstabilisiertes ZrO₂ vorgeschlagen. Zur Herstellung einer solchen Schicht nach dem CVD-Verfahren werden Aluminiumtrichlorid, Kohlendioxid und Wasserstoff in die Gasphase zur Bildung von Al₂O₃ sowie Zirkontetrachlorid und Wasserdampf zur Bildung von ZrO₂ in einen Reaktionsbehälter bei 1100°C eingelassen. Durch den Dichteunterschied zwischen der oberhalb einer Umwandlungstemperatur von etwa 1100°C beständigen tetragonalen und der unterhalb von etwa 1100°C beständigen. monoklinen Modifikation des Zirkoniumoxids ist bei einer entsprechenden Phasenumwandlung eine erhebliche Volumenänderung des eingelagerten Zirkoniumoxids gegeben. Hieraus folgt, daß mit zunehmendem Volumenanteil des Zirkoniumoxids gleichzeitig die Mikrorißdichte in der abgeschiedenen keramischen Schicht erhöht wird.

In der DE 28 25 009 C2 wird eine Hartmetallkörper mit einer dünnen verschleißfesten Oberflächenschicht aus Aluminiumoxid beschrieben, das ganz oder zu wenigstens 85 % aus der κ-Modifikation besteht und daß ein ggf. aus der α-Modifikation bestehender Rest auf der Oberfläche Bereiche bzw. Flecke mit einer Größe von höchstens 10 µm bildet. Die Aluminiumoxidschicht kann zusätzlich Zusätze an Titan, Zirkonium und/oder Hafnium enthalten. Zur Herstellung dieser keramischen Schicht mittels des CVD-Verfahrens werden der Gasmischung neben H₂, AlCl₃, CO₂ und CO noch geringe Mengen von 0,03 bis 0,5 % TiCl₄ zugesetzt.

Dieser Zusatz dient jedoch ausschließlich oder beinahe ausschließlich zur Bildung der κ-Aluminiumoxid-Phase.

Ein weiteres CVD-Verfahren zur Abscheidung von Al₂O₃- und/oder ZrO₂ unter Verwendung von einem zusätzlichen Reagenz, wie Schwefelwasserstoff, wird in der EP 0 523 021 B1 beschrieben.

Die DE 195 18 927 A1 beschreibt ein beschichtetes Schneidwerkzeug, bestehend aus einem Sintercarbid- oder Keramiksubstrat mit einem verschleißfesten Verbundkeramiküberzug, der zwei unterschiedliche Metalloxidphasen, z.B. aus Al₂O₃ und ZrO₂, sowie außerdem ein Dotierungsmittel aufweist, das aus der Gruppe Schwefel, Selen, Tellur, Phosphor, Arsen, Antimon, Wismut oder Verbindungen der genannten Elemente ausgewählt ist. Zur Herstellung dieser zweiphasigen Schicht nach einem CVD-Verfahren werden beispielsweise Aluminium- und Zirkon-Chlorid, Kohlendioxid mit Wasserstoff als Träger neben einem H₂S-Gas bei einer Temperatur von etwa 700 bis 1250°C und einem Druck von 133 Pa bis Umgebungsdruck über den Substratkörper geleitet, wodurch sich die zweiphasige Schicht mit dem Dotierungsmittel abscheidet.

Die EP 0 786 536 A1 beschreibt einen beschichteten Hartmetallkörper mit einer 3 bis 20 µm dicken Aluminiumoxidschicht, die mittels CVD und/oder PVD abgeschieden worden ist und die 0,005 bis 0,5 Gewichts-% Chlor enthalten soll. Fakultativ können in dieser Schicht 0,5 bis 10 Gewichts-% Zr und/oder Hf sowie 1,5 bis 15 Gewichts-% Ti enthalten sein.

Die EP 0 162 656 A2 beschreibt eine Viellagenbeschichtung auf einem Hartmetall-Substratkörper mit einer inneren Schicht, die aus wenigstens einem Carbid, Nitrid, Carbonitrid, Carbooxinitrid, Oxinitrid, Bornitrid oder Borcarbonitrid des Titans und einer äußeren Viellagenschicht mit einer Gesamtdicke von 5 bis 20 µm besteht, die aus einer Mehrzahl von Al₂O₃-Schichten mit einer jeweiligen Dicke von 0,01 bis 2 µm besteht, von denen jede aus einem Al₂O₃-Film besteht, in dem Titanoxid gelöst oder zumindest 30 Volumen-% des Titanoxids coexistent sind. Die Lagen sind durch Zwischenschichten einer jeweiligen Dicke von 0,01 bis 2 µm getrennt, die jeweils aus TiC, TiN, TiCN, TiCNO, TiNO, Titanoxiden, Ti(BN), Ti(BNC), SiC, AlN und AlON bestehen.

Es ist Aufgabe der vorliegenden Erfindung, die Verschleißfestigkeit des eingangs genannten Verbundwerkstoffes zu verbessern. Insbesondere bei der Verwendung dieses Verbundwerkstoffes als Schneideinsatz zur spanabhebenden Materialbearbeitung soll eine Standzeit- und Leistungsverbesserung erzielt werden.

Diese Aufgabe wird durch den Verbundwerkstoff nach Anspruch 1 gelöst, der erfindungsgemäß dadurch gekennzeichnet ist, daß die Al₂O₃ und eine zweite Phase ZrO₂ und/oder HfO₂ enthaltende Schicht zusätzlich eine dritte feindispersive Phase, bestehend aus einem Oxid, Oxicarbid, Oxinitrid oder Oxicarbonitrid des Titans, aufweist, die aus einzelnen Kristalliten einer Größe besteht, die kleiner als 1/100 der Größe der Kristallite der Al₂O₃- und der ZrO₂- und/oder HfO₂-Phasen ist. Insbesondere kann die dritte Phase aus TiO₂, TiO, Ti₂O, Ti₂O₃, Ti(O,C), Ti(O,N) oder Ti(O,C,N) oder Mischphasen hieraus bestehen, die im folgenden allgemein als TiOₓ-Phasen bezeichnet werden. Die Einlagerung der TiOₓ-Verbindungen in die zweiphasige Keramikschicht wird vorteilhafterweise eine dispersionsverfestigende Wirkung erzielt, welche die Verschleißfestigkeit dieser Schicht erheblich verbessert.

Nach einer besonderen Ausgestaltung der Erfindung beträgt der Anteil dieser dritten Phase (TiOₓ) an der Gesamtmenge der keramischen Schicht 0,2, vorzugsweise 0,6, bis 5 Mol%, weiterhin vorzugsweise mindestens 1 Mol%. Das Mol-Verhältnis der Al₂O₃-Phase zu der ZrO₂-, HfO₂- oder ZrO₂/HfO₂-Phase, die auch als Mischoxid (Zr, Hf)O₂ ausgebildet sein kann, wird je nach Bedarf, d.h. nach Verwendungszweck des Verbundwerkstoffes angepaßt. Es ist allgemein bekannt, daß Aluminiumoxid bei 1000°C eine hohe Härte und eine geringe Wärmeleitfähigkeit aufweist. Die bei Verwendung des Verbundwerkstoffes als Schneideinsatz bei der Zerspanung entstehende Wärme wird daher hauptsächlich in den Span und nur zu einem geringen Teil in den Schneideinsatz geleitet, was die Gefahr von plastischen Verformungen der Schneidkante herabsetzt. Aluminiumoxid ist auch bei hohen Temperaturen oxidationsbeständig, die Verschleißneigung mit Eisenwerkstoffen sowie der Reibungskoeffizient sind gering. Allerdings besteht bei der Abscheidung von reinen Al₂O₃-Schichten das Problem, daß das Kornwachstum bei der Abscheidung nur schwer beherrschbar ist. Das ZrO₂ oder HfO₂, die im Vergleich zum Al₂O₃ noch beständiger gegen chemische Reaktionen sind und gegenüber Eisenwerkstoffen außerordentlich niedrige Reibwerte haben, sind demgegenüber weicher als das Al₂O₃, haben jedoch den Vorteil, daß sie bei der gemeinsamen Abscheidung mit Al₂O₃ das Kristallit-Wachstum der Al₂O₃-Phase und auch im Verbund den Reibkoeffizienten vermindern. Darüber hinaus erhöht der ZrO₂-und/oder HfO₂-Anteil in der Al₂O₃-Schicht deren wärmeisolierende Wirkung, da z.B. ZrO₂ nur 1/10 der Wärmeleitfähigkeit im Vergleich zum Al₂O₃ hat. Je nach Verwendungszweck, bei dem die bessere chemische Inertheit, die verbesserte Wärmeisolation des ZrO₂ bzw. HfO₂ oder die höhere Verschleißfestigkeit des Al₂O₃ gegen Abrieb ausgenutzt werden soll, wählt man das betreffende Verhältnis der beiden Phasen. Vorzugsweise liegt das Verhältnis der Al₂O₃-Phase zu der ZrO₂-, HfO₂- oder ZrO₂/HfO₂-Phase zwischen 9/10 und 10/1, wobei das ZrO₂ und HfO₂ in monokliner und/oder tetragonaler Form vorliegen kann.

Die dritte, feinkristalline Phase weist Kristallite einer Größe auf, die kleiner als 1/100 der Größe der Kristallite der Al₂O₃- und der ZrO₂- bzw. HfO₂-Phasen ist.

Nach einer weiteren Ausgestaltung der Erfindung ist die Verbundwerkstoff-Beschichtung mehrlagig und besitzt mindestens eine Schicht aus einem Carbid, Nitrid, Carbonitrid eines der Elemente der IVa- bis VIa-Gruppe des Periodensystemes. Hierbei wird insbesondere als Zwischenschicht zwischen dem Grundkörper und der äußeren Schicht aus Al₂O₃/ZrO₂ (ggf. ganz oder teilweise durch HfO₂ ersetzt)/TiOₓ eine Schicht aus TiN und/oder Ti(C,N) angeordnet. Dieser Schichten verhindern die Gefahr des Abplatzens der relativ spröden keramischen Überzüge von dem Grundkörper.

Die Dicke der Al₂O₃/ZrO₂ bzw. HfO₂/TiOₓ-Schicht liegt bevorzugt zwischen 1 µm und 10 µm, insbesondere zwischen 2 µm und 8 µm. Die Gesamtdicke der Beschichtung sollte 25 µm nicht übersteigen.

In einer speziellen Ausführungsform besitzt die auf dem Grundkörper abgeschiedene erste Schicht aus einem Titannitrid oder Titancarbonitrid eine Dicke zwischen 3 und 8 µm und die aus Al₂O₃/ZrO₂ bzw. HfO₂/TiOₓ bestehende zweite Schicht eine Dicke zwischen 2 und 8 µm, wobei diese zweite Schicht entweder die äußere Schicht ist oder wobei auf diese zweite Schicht eine Auβenlage aus TiN, ZrO₂ oder ZrCN mit einer Dicke zwischen 1 und 5 µm abgeschieden worden ist.

Zur CVD-Abscheidung der vorbeschriebenen Al₂O₃-ZrO₂- bzw. HfO₂-TiOₓ-Schicht werden Abscheidetemperaturen zwischen 900°C und 1000°C gewählt. 900°C sollten möglichst wegen der dann zu geringen Abscheiderate ebensowenig unterschritten werden wie Abscheidetemperaturen von 1000°C überschritten werden, da bei hohen Temperaturen im Bereich der Kanten des Verbundwerkstoffes zu dicke Abscheidungen auftreten, die insbesondere bei Verwendung des Verbundwerkstoffes als Schneideinsatz leicht zu unerwünschten Ablösungen (Abbröckelungen) führen. Der Druck in der Gasatmosphäre, die sich aus AlCl₃, ZrCl₄, HfCl₄, CO₂, H₂, CH₄ und N₂ oder Inertgasen zusammensetzt, beträgt 10 bis 100000 Pa. Die Gasphase enthält 0,2 bis 5 Mol% TiCl₄. Das CVD-Verfahren ist grundsätzlich nach dem Stand der Technik bekannt, z.B. aus der eingangs zitierten DE 195 18 927 A1.

Nach einer weiteren Ausgestaltung beträgt der Gasphasenanteil des AlCl₃ 1 bis 5 Mol% und/oder der Gasphasenanteil des ZrCl₄ und/oder HfCl₄ 0,2 bis 5 Mol%, um die gewünschten relativen prozentualen Anteile der Al₂O₃-Phase zu der ZrO₂- bzw. HfO₂-Phase zu erhalten. Vorzugsweise liegt der Gasphasendruck unter 10000 Pa, insbesondere bei 8000 Pa. Zur Abscheidung einer mehrlagigen Beschichtung auf einem Hartmetall-Grundkörper, der eine Zusammensetzung mit 94 M% WC, Rest Co besaß, ist ein CVD-Verfahren mit einer Gasphasentemperatur von 1000°C gewählt worden. Der Druck der jeweiligen Gasphase lag bei 8000 Pa.

In einem ersten Ausführungsbeispiel ist auf den genannten Hartmetallkörper eine Schichtfolge TiN, Ti(C,N) und die beschriebene Al₂O₃/ZrO₂/TiOₓ-Außenlage aufgetragen worden. Die einzelnen Schichtdicken sowie die verwendeten Gase können der nachfolgenden Tabelle entnommen werden.

| Einzelschicht | Dicke (µm) | Verwendete Gase |
|---|---|---|
| TiN | 2,0 | H₂, N₂, TiCl₄ |
| Ti(C,N) | 4,1 | H₂, N₂, CH₄, TiCl₄ |
| Al₂O₃/ZrO₂/TiOₓ | 8,1 | H₂, CO₂, AlCl₃, |
| | | TiCl₄, CH₄, ZrCl₄, |
| | | N₂ |
| gesamte Dicke | 14,2 | |

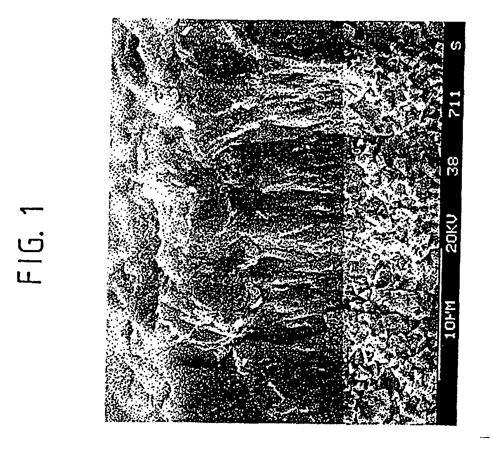

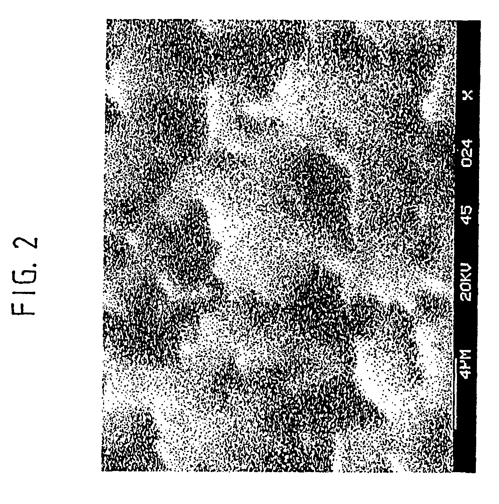

Die Gasphasenzusammensetzung bei der Abscheidung der Außenlage bestand aus 10 l AlCl₃, 2,5 l ZrCl₄, 1,6 l TiCl₄, 20 l CO₂, 40 l N₂, 320 1 H₂ und 15 1 CH₄. Das Schichtgefüge ist Fig. 1 zu entnehmen, die eine REM-Bruchgefügeaufnahme zeigt. Wie insbesondere der vergrößerten REM-Gefügeaufnahme der Außenlage nach Fig. 2 zu entnehmen ist, besaß die Außenlage als dunkle Phasen erscheinende Al₂O₃-Anteile, als helle Phase erscheinende ZrO₂-Anteile sowie als weiße Punkte sichtbare TiOₓ-Phase. Diese Phase hat eine Kristallitgröße, die weniger als 1/100 der Kristallitgröße der beiden anderen Phasen aus Al₂O₃ und ZrO₂ beträgt.

Im Vergleich hierzu ist auf ein Substratkörper, der ebenfalls die Zusammensetzung 94 M% WC, 6 M% Co aufwies, die nachfolgend aufgeführte Schichtfolge aufgetragen worden.

| Einzelschicht | Dicke (µm) | Verwendete Gase |
|---|---|---|
| TiN | 2,0 | H₂, N₂, TiCl₄ |
| Ti(C,N) | 4,0 | H₂, N₂, CH₄, TiCl₄ |
| Al₂O₃ | 7,6 | H₂, CO₂, AlCl₃ |
| gesamte Dicke | 13,6 | |

Eine solche Schichtfolge mit einer Al₂O₃-Außenlage ist nach dem Stand der Technik bekannt. Derartige Verbundkörper in Form von Wendeschneidplatten mit einer SNUN120412-Geometrie entsprechend der Schichtzusammensetzung gemäß vorstehender Tabellen sind zum Drehen einer Welle aus Grauguß der Sorte GG25 unter folgenden Schnittbedingungen eingesetzt worden:

| | |
|---|---|
| Schnittgeschwindigkeit | vc = 400 m/min |
| Schnittiefe | ap = 2,5 mm |
| Vorschub | f = 0,31 mm/Umdrehung |
| Verschleiß | VB = 0,5 mm |

Mit den nach dem Stand der Technik bekannten Wendeschneidplatten, die eine Al₂O₃-Außenlage aufwiesen, konnten Standzeiten von ca. 4 Minuten im Mittel erreicht werden. Die erfindungsgemäß beschichteten Wendeschneidplatten mit einer Al₂O₃/ZrO₂/TiOₓ-Außenlage erreichten hingegen unter den vorgestellten Schnittbedingungen Standzeiten von 13,7 Minuten. Dies bedeutet, daß der erfindungsgemäße Schneideinsatz eine erheblich verbesserte. Verschleißfestigkeit besitzt.

In einem weiteren Anwendungsbeispiel wurden Wendeschneidplatten mit einer nach dem Stand der Technik bekannten Beschichtung und einer erfindungsgemäßen Beschichtung zum Fräsen eingesetzt. Die Schneideinsätze besaßen die Geometrie RDMW1605. Als Substratkörper diente hier ebenfalls ein Hartmetall-Körper mit 94 M% WC und 6 M% Co. Die nach dem Stand der Technik bekannten Einzelschichten lagen wie folgt vor:

| Einzelschicht | Dicke (µm) | Verwendete Gase |
|---|---|---|
| TiN | 1,5 | H₂, N₂, TiCl₄ |
| Ti(C,N) | 2,8 | H₂, CH₃CN, TiCl₄ |
| Al₂O₃ | 2,3 | H₂, CO₂, AlCl₃ |
| gesamte Dicke | 6,6 | |

Die erfindungsgemäße Beschichtung wurde unter einer Gasphasentemperatur von 980°C wie folgt abgeschieden:

| Einzelschicht | Dicke (µm) | Verwendete Gase |
|---|---|---|
| TiN | 1,2 | H₂, N₂, TiCl₄ |
| Ti(C,N) | 3,0 | H₂, CH₃CN, TiCl₄ |
| Al₂O₃/ZrO₂/TiOₓ | 2,6 | H₂, CO₂, AlCl₃, |
| | | TiCl₄, CH₄, N_{2,} |
| | | ZrCl₄ |
| gesamte Dicke | 6,8 | |

Hierbei ist zusätzlich N₂ in einer Menge von 20 l in die Gasphase eingeleitet worden. Die hergestellten Serien von Wendeschneidplatten in einer nach dem Stand der Technik bekannten Ausführungsform mit einer äußeren Al₂O₃-Beschichtung sowie eine Serie von Wendeschneidplatten mit der erfindungsgemäßen Beschichtung sind zum Planfräsen eines Werkstückes aus einem 56NiCrMoV7 Werkstoff mit einer Festigkeit bei 1300 N/mm² unter folgenden Schnittbedingungen eingesetzt worden:

| | |
|---|---|
| Schnittgeschwindigkeit | vc = 315 m/min |
| Schnittiefe | ap = 0,5 mm |
| Eingriffsbreite | ae = 67,2 mm |
| Vorschub | fz = 0,31 mm/Zahn |
| Verschleiß | VB = 0,3 mm |

Die mit nach dem Stand der Technik bekannten Schneideinsätzen erreichbare Lauflänge pro Schneide betrug 4000 mm im Mittel, während erfindungsgemäße Schneidplatten eine mittlere Lauflänge von 13000 mm erreichten. Auch hier ist eine um mehr als das Dreifache höhere Standfestigkeit festzustellen.

Anstelle des Hartmetall-Grundkörpers können auch Cermets bekannter Zusammensetzung verwendet werden. Ebenso können für spezielle Anwendungsfälle auf die erfindungsgemäße keramische Außenlage noch jeweils eine zusätzliche Deckschicht aus ZrCN, HfCN und/oder ZrO₂, HfO₂ oder TiN aufgetragen werden.

In einem weiteren Anwendungsbeispiel wurden Wendeschneidplatten mit einer nach dem Stand der Technik bekannten Beschichtung und einer erfindungsgemäßen Beschichtung zum Fräsen eingesetzt. Die Schneideinsätze besaßen die Geometrie RDMW1605. Als Substratkörper diente hier ebenfalls ein Hartmetall-Körper mit 94 M% WC und 6 M% Co. Die nach dem Stand der Technik bekannten Einzelschichten lagen wie folgt vor:

| Einzelschicht | Dicke (µm) | Verwendete Gase |
|---|---|---|
| TiN | 1,5 | H₂, N₂, TiCl₄ |
| Ti(C,N) | 4,8 | H₂, CH₃CN, TiCl₄ |
| Al₂O₃ | 5,3 | H₂, CO₂, AlCl₃ |
| gesamte Dicke | 11,6 | |

Die erfindungsgemäße Beschichtung wurde unter einer Gasphasentemperatur von 980°C wie folgt abgeschieden:

| Einzelschicht | Dicke (µm) | Verwendete Gase |
|---|---|---|
| TiN | 1,2 | H₂, N₂, TiCl₄ |
| Ti(C,N) | 4,8 | H₂, CH₃CN, TiCl₄ |
| Al₂O₃/HfO₂/TiOₓ | 6,0 | H₂, CO₂, AlCl₃, |
| | | TiCl₄, CH₄, HfCl₄ |
| gesamte Dicke | 12,0 | |

Die hergestellten Serien von Wendeschneidplatten in einer nach dem Stand der Technik bekannten Ausführungsform mit einer äußeren Al₂O₃-Beschichtung sowie eine Serie von Wendeschneidplatten mit der erfindungsgemäßen Beschichtung sind zum Planfräsen eines Werkstückes aus einem GG25 Werkstoff (HB = 180 - 240) unter folgenden Schnittbedingungen eingesetzt worden:

| | |
|---|---|
| Schnittgeschwindigkeit | vc = 570 m/min |
| Schnittiefe | ap = 2,0 mm |
| Eingriffsbreite | ae = 62,5 mm |
| Vorschub | fz = 0,20 mm/Zahn |
| Verschleiß | VB = 0,3 mm |

Die mit nach dem Stand der Technik bekannten Schneideinsätzen erreichbare Lauflänge pro Schneide betrug 5000 mm im Mittel, während erfindungsgemäße Schneidplatten eine mittlere Lauflänge von 15000 mm erreichten. Auch hier ist eine um das Dreifache höhere Standfestigkeit festzustellen.

In einem weiteren Anwendungsbeispiel wurden Wendeschneidplatten mit einer nach dem Stand der Technik bekannten Beschichtung und einer erfindungsgemäßen Beschichtung zum Fräsen eingesetzt. Die Schneideinsätze besaßen die Geometrie RDMW1605. Als Substratkörper diente hier ebenfalls ein Hartmetall-Körper mit 94 M% WC und 6 M% Co. Die nach dem Stand der Technik bekannten Einzelschichten lagen wie folgt vor:

| Einzelschicht | Dicke (µm) | Verwendete Gase |
|---|---|---|
| TiN | 1,0 | H₂, N₂, TiCl₄ |
| Ti(C,N) | 4,9 | H₂, CH₃CN, TiCl₄ |
| Al₂O₃ | 6,3 | H₂, CO₂, AlCl₃ |
| gesamte Dicke | 12,2 | |

Die erfindungsgemäße Beschichtung wurde unter einer Gasphasentemperatur von 980°C wie folgt abgeschieden:

| Einzelschicht | Dicke (µm) | Verwendete Gase |
|---|---|---|
| TiN | 1,5 | H₂, N₂, TiCl₄ |
| Ti(C,N) | 4,1 | H₂, CH₃CN, TiCl₄ |
| Al₂O₃/(Zr,Hf)O₂/TiOₓ | 7,0 | H₂, CO₂, AlCl₃, |
| | | TiCl₄, CH₄, N_{2,} |
| | | ZrCl₄, HfCl₄ |
| gesamte Dicke | 12,6 | |

Die hergestellten Serien von Wendeschneidplatten in einer nach dem Stand der Technik bekannten Ausführungsform mit einer äußeren Al₂O₃-Beschichtung sowie eine Serie von Wendeschneidplatten mit der erfindungsgemäßen Beschichtung sind zum Planfräsen eines Werkstückes aus einem GGG70 Werkstoff (HB = 250 - 300) unter folgenden Schnittbedingungen eingesetzt worden:

| | |
|---|---|
| Schnittgeschwindigkeit | vc = 350 m/min |
| Schnittiefe | ap = 2,0 mm |
| Eingriffsbreite | ae = 25,0 mm |
| Vorschub | fz = 0,25 mm/Zahn |
| Verschleiß | VB = 0,5 mm |

Die mit nach dem Stand der Technik bekannten Schneideinsätzen erreichbare Lauflänge pro Schneide betrug 1500 mm im Mittel, während erfindungsgemäße Schneidplatten eine mittlere Lauflänge von 4000 mm erreichten.

Soweit die Verbundkörper als Schneideinsätze ausgebildet sind, eignen sich diese zum Drehen, Fräsen, hier insbesondere dem Hochgeschwindigkeitsfräsen.

## Patentansprüche

1. Verbundwerkstoff aus einem beschichteten Hartmetall- oder Cermetgrundkörper, auf dem die einzige oder bei einer mehrlagigen Beschichtung mindestens eine 0,5 um bis 25 µm dicke Schicht, vorzugsweise die äußerste, eine Al₂O₃- und eine Phase enthält, die aus ZrO₂ und/oder HfO₂ besteht,
**dadurch gekennzeichnet,**
**daß** die Al₂O₃- und eine zweite Phase aus ZrO₂ und/oder HfO₂ enthaltende Schicht eine dritte feindispersive Phase, bestehend aus einem Oxid, Oxidcarbid, Oxinitrid oder Oxicarbonitrid des Titans aufweist, die aus einzelnen Kristalliten einer Größe besteht, die kleiner als 1/100 der Größe der Kristallite der Al₂O₃- und der ZrO₂- und/oder HfO₂-Phasen ist.

2. Verbundwerkstoff nach Anspruch 1, **dadurch gekennzeichnet, daß** die dritte Phase aus TiO₂, TiO, Ti₂O, Ti₂O₃, Ti(O,C), Ti(O,N) oder Ti(O,C,N) oder Mischphasen hieraus besteht.

3. Verbundwerkstoff nach einem der Ansprüche 1 oder 2, **dadurch gekennzeichnet, daß** der Anteil der dritten Phase an der Gesamtmenge dieser Schicht 0,2, vorzugsweise 0,6 bis 5 Mol%, weiterhin vorzugsweise mindestens 1 Mol% beträgt und daß das Mol-Verhältnis der Al₂O₃-Phase zu der ZrO₂- und/oder HfO₂-Phase zwischen 9/10 und 10/1 liegt, wobei das ZrO₂ und/oder HfO₂ in monokliner und/oder tetragonaler Form vorliegt.

4. Verbundwerkstoff nach einem der Ansprüche 1 bis 3, **dadurch gekennzeichnet, daß** die Beschichtung mehrlagig ist und mindestens eine Schicht aus einem Carbid, Nitrid, Carbonitrid eines der Elemente der IVa- bis VIa-Gruppe des Periodensystemes besteht.

5. Verbundwerkstoff nach Anspruch 4, **gekennzeichnet durch** eine auf den Grundkörper abgeschiedene Schichtfolge aus TiN, Ti(C,N) und eine äußere Schicht aus Al₂O₃/ZrO₂ und/oder HfO₂/TiOₓ mit TiOₓ = TiO₂, TiO, Ti₂O, Ti₂O₃, Ti(O,C), Ti(O,N) oder Ti(O,C,N) oder Mischphasen hieraus.

6. Verbundwerkstoff nach einem der Ansprüche 1 bis 5, **dadurch gekennzeichnet, daß** die Dicke der Al₂O₃/ZrO₂ und/oder HfO₂/TiOₓ-Schicht zwischen 1 µm und 10 µm, vorzugsweise zwischen 2 µm und 8 µm, liegt und/oder daß die Gesamtdicke der Beschichtung 25 µm nicht übersteigt.

7. Verbundwerkstoff nach einem der Ansprüche 4 bis 6, **dadurch gekennzeichnet, daß** die auf dem Grundkörper abgeschiedene erste Schicht eine Dicke zwischen 3 µm und 8 µm und die aus Al₂O₃/ZrO₂ und/oder HfO₂/TiOₓ bestehende zweite Schicht eine Dicke zwischen 2 µm und 8 µm besitzt, wobei diese zweite Schicht entweder die äußere Schicht ist oder wobei auf diese zweite Schicht eine Außenlage aus TiN, ZrO₂, HfO₂, ZrCN oder HfCN mit einer Dicke zwischen 1 µm und 5 µm abgeschieden worden ist.

## Claims

1. Composite material of a coated hart metal or cermet substrate body, upon which a sole or in the case of a multiple layer coating at least one layer with a thickness of 0,5 µm to 25 µm, preferably the outermost layer, contains an Al₂O₃ phase and a phase consisting of ZrO₂ and/or HfO₂,
**characterized in that**
in the layer containing Al₂O₃ and a second phase of ZrO₂ and/or HfO₂ contains a third finely dispersed phase consisting of oxide, oxicarbide, oxinitride or oxicarbonitride of titanium and of individual crystallites of a size which is smaller than 1/100 of the crystallite size of the Al₂O₃ and the ZrO₂ and/or HfO₂ phases.

2. Composite material according to claim 1, **characterized in that** the third phase consists of TiO₂, TiO, Ti₂O, Ti₂O₃, Ti(O,C), Ti(O,N) or Ti(O,C,N) or mixed phases thereof.

3. Composite material according to one of claims 1 or 2, **characterized in that** the ratio of the third phase in relation to the total amount of this layer is 0,2, preferably 0,6 to 5 % by mol, furthermore preferably at least 1 % by mol, and that the mol ratio of the Al₂O₃ phase to the ZrO₂ and/or HfO₂ phase lies between 9/10 and 10/1, whereby the ZrO₂ and/or HfO₂ is present in monoclinal and/or tetragonal form.

4. Composite material according to one of claims 1 to 3, **characterized in that** the coating is multilayered and at least one layer consists of a carbide, nitride, carbonitride of an element of the Groups IVa to VIa of the classification of elements.

5. Composite material according to claim 4, **characterized in that** a layer sequence deposited on the substrate body consists of TiN, Ti(C,N) and an outer layer of Al₂O₃/ZrO₂ and/or HfO₂/TiOₓ with TiO₂ = TiO₂, TiO, Ti₂O, Ti₂O₃, Ti(O,C), Ti(O,N) or Ti(O,C,N) or mixed phases thereof.

6. Composite material according to one of claims 1 to 5, **characterized in that** the thickness of the Al₂O₃/ZrO₂ and/or HfO₂/TiO₂/TiOₓ layer ranges between 1 µm and 10 µm, preferably between 2 µm and 8 µm and that the total thickness of the coating does not surpass 25 µm.

7. Composite material according to one of claims 4 to 6, **characterized in that** the first layer deposited on the substrate body has a thickness between 3 µm and 8 µm and the second layer consisting of Al₂O₃/ZrO and/or HfO₂/TiOₓ has a thickness between 2 µm and 8 µm, whereby this second layer is either the outer layer or whereby on this second layer an outer coating of TiN, ZrO₂, HfO₂, ZrCN or HfCN with a thickness between 1 µm and 5 µm was deposited.

## Revendications

1. Matériau composite se composant d'un corps de base revêtu en métal dur ou en cermet, sur lequel la couche unique ou, dans le cas d'un revêtement à plusieurs couches, au moins une couche ayant une épaisseur de 0,5 µm à 25 µm, de préférence la couche la plus extérieure, comprend une phase d'Al₂O₃ et une phase qui se compose de ZrO₂ et/ou de HfO₂, **caractérisé par le fait que** la couche contenant de l'Al₂O₃ et une deuxième phase en ZrO₂ et/ou en HfO₂ présente une troisième phase finement dispersée consistant en un oxyde, en un oxycarbure, en un oxynitrure ou en un oxycarbonitrure du titane, ladite troisième phase se composant de cristallites individuels d'une grosseur qui est plus petite que 1/100 de la grosseur des cristallites de la phase d'Al₂O₃ et de la phase de ZrO₂ et/ou de HfO₂.

2. Matériau composite selon la revendication 1, **caractérisé par le fait que** la troisième phase se compose de TiO₂, TiO, Ti₂O, Ti₂O₃, Ti(O,C), Ti(O,N) ou Ti(O,C,N) ou de phases mixtes de cela.

3. Matériau composite selon l'une des revendications 1 ou 2, **caractérisé par le fait que** la part de la troisième phase à la quantité totale de cette couche est de 0,2, de préférence de 0,6 à 5 % molaire, en outre de préférence d'au moins 1 % molaire, et que le rapport molaire de la phase d'Al₂O₃ à la phase de ZrO₂ et/ou de HfO₂ est compris entre 9/10 et 10/1, le ZrO₂ et/ou HfO₂ étant présent sous forme monoclinique et/ou tétragone.

4. Matériau composite selon l'une des revendications 1 à 3, **caractérisé par le fait que** le revêtement présente plusieurs couches et qu'au moins une couche se compose d'un carbure, d'un nitrure, d'un carbonitrure de l'un des éléments du groupe IVa à VIa de la classification périodique des éléments.

5. Matériau composite selon la revendication 4, **caractérisé par** une suite de couches déposée sur le corps de base, qui se compose de TiN, Ti(C,N) et par une couche extérieure en Al₂O₃/ZrO₂ et/ou en HfO₂/TiOₓ avec TiOₓ = TiO₂, TiO, Ti₂O, Ti₂O₃, Ti(O,C), Ti(O,N) ou Ti(O,C,N) ou des phases mixtes de cela.

6. Matériau composite selon l'une des revendications 1 à 5, **caractérisé par le fait que** l'épaisseur de la couche en Al₂O₃/ZrO₂ et/ou en HfO₂/TiOₓ est comprise entre 1 µm et 10 µm, de préférence entre 2 µm et 8 µm, et/ou que l'épaisseur totale du revêtement ne dépasse pas 25 µm.

7. Matériau composite selon l'une des revendications 4 à 6, **caractérisé par le fait que** la première couche déposée sur le corps de base présente une épaisseur comprise entre 3 µm et 8 µm et la deuxième couche se composant d'Al₂O₃/ZrO₂ et/ou de HfO₂/TiOₓ présente une épaisseur comprise entre 2 µm et 8 µm, soit cette deuxième couche étant la couche extérieure soit un revêtement extérieur en TiN, ZrO₂, HfO₂, ZrCN ou en HfCN avec une épaisseur comprise entre 1 µm et 5 µm ayant été appliqué sur cette deuxième couche.
